# EUROPÄISCHE PATENTANMELDUNG

(11) **EP 0 797 312 A2**
(43) Veröffentlichungstag der Anmeldung: **24.09.1997**
(21) Anmeldenummer: 97103795.7
(22) Anmeldetag: 07.03.1997
(51) Int. Cl.: H04B 1/44

(54) **Sende-Empfangs-Umschalter mit Halbleitern**

(30) Priorität: 19.03.1996 DE 19610760
(71) Anmelder: TEMIC TELEFUNKEN microelectronic GmbH, 74072 Heilbronn (DE)
(72) Erfinder: Nosswitz, Manfred, 80993 München (DE)
(74) Vertreter: Maute, Hans-Jürgen, Dipl.-Ing.

(57) **Zusammenfassung**

Ein Sende-Empfangs-Umschalter mit einem dem Sendeweg vom Senderanschluß zum Antennenanschluß und einem dem Empfangsweg vom Antennenanschluß zum Empfängeranschluß zugeordneten steuerbaren Halbleiterelement als Hochfrequenzschalter, mit Anschlüssen zum Zuführen eines Steuersignals (Strom oder Spannung) zu den Halbleiterelementen, wobei die Halbleiterelemente in Abhängigkeit von ihrer Ansteuerung durch ein Steuersignal einen für die zu schaltende Hochfrequenz annähernd ohmschen steuerbaren Widerstand bilden, ist dadurch gekennzeichnet, daß die Anordnung derart getroffen ist, daß mindestens eines (D3) der Halbleiterelemente unabhängig von einem anderen Halbleiterelement steuerbar ist, derart, daß dann, wenn der Empfängeranschluß (RX) mit dem Antennenanschluß (ANT) gekoppelt ist, die dem Empfängeranschluß zuführbare Hochfrequenzleistung durch die Steuerung des mindestens einen Halbleiterelements veränderbar ist. Dadurch werden zum Dämpfen der dem Empfängereingang zugeführten Hochfrequenz keine zusätzlichen Bauelemente benötigt.

## Beschreibung

Die Erfindung betrifft einen Sende-Empfangs-Umschalter mit einem Senderanschluß, einem Empfängeranschluß und einem Antennenanschluß zum Anschluß eines Hochfrequenz-Senderausgangs, Empfängereingangs bzw. einer Antenne, mit einem dem Sendeweg vom Senderanschluß zum Antennenanschluß und einem dem Empfangsweg vom Antennenanschluß zum Empfängeranschluß zugeordneten steuerbaren Halbleiterelement als Hochfrequenzschalter, mit Anschlüssen zum Zuführen eines Steuersignals (Strom oder Spannung) zu den Halbleiterelementen, wobei die Halbleiterelemente in Abhängigkeit von ihrer Ansteuerung durch ein Steuersignal einen für die zu schaltende Hochfrequenz annähernd ohmschen steuerbaren Widerstand bilden.

Durch DE 32 03 961 C2 ist ein elektronischer Sende-Empfangs-Schalter für einen Senderempfänger (Transceiver) bekannt, der von stromgesteuerten Dioden Gebrauch macht. Bei Senderempfängern, die mit derartigen Empfangsumschaltern ausgerüstet sind, wird eine bei sehr starkem Empfangssignal erforderliche Absenkung des Hochfrequenzpegels in der ersten Hochfrequenzverstärkerstufe des Empfängers vorgenommen. Für ein hierzu erforderliches Dämpfungsglied ist es bekannt, pin-Dioden zu verwenden, die oberhalb einer bestimmten Hochfrequenz, z.B. 1 MHz, für die Hochfrequenz einen im wesentlichen ohmschen Widerstand bilden, der durch einen die pin-Diode durchfließenden Gleichstrom einstellbar ist. Fließt kein Gleichstrom durch die pin-Diode, so ist diese für die Hochfrequenz hochohmig. Für derartige Dämpfungsglieder können anstatt von pin-Dioden auch GaAs-Feldeffekttransistoren verwenden werden.

Ein Hochfrequenz-Diodenschalter, der zur Verwendung als Sende-Empfangs-Umschalter vorgesehen ist, ist auch aus einem Prospekt vom Juni 1994 der Firma muRata, Multilayer Component Dept., New Business Development Division, mit der Nummer No. LMX-PR-014 bekannt. Dieser Umschalter weist zwei Dioden und zwei Lambda/4-Leitungsstücke auf, und es sind Hochfrequenzanschlüsse für den Sender, den Empfänger und die Antenne vorgesehen, und außerdem zwei Steueranschlüsse, an die beim Senden die Spannungen +5 Volt und 0 Volt und beim Empfangen die Spannungen 0 Volt und +5 Volt angelegt werden, wobei beim Senden beide Dioden von einem Gleichstrom durchflossen werden und dadurch der Weg vom Sender zur Antenne leitend ist und der Eingang des Empfängers HF-mäßig kurzgeschlossen ist, wogegen bei der anderen Polarität der den Steueranschlüssen zugeführten Spannung beide Dioden gesperrt sind, wodurch die Hochfrequenz nur vom Antennenanschluß zum Empfänger gelangen kann.

Für die Empfangspegelabsenkung im Bereich der ersten Empfängerstufe ist es bekannt, anstatt einer eigens hierfür vorgesehenen pin-Diode einen Dual-Gate-MOS-FET zu verwenden mit Steuerung am Gate 2, oder einen GaAs-FET mit Gatespannungssteuerung zu verwenden, einen Transistor mit Arbeitspunktverstellung, oder etwa auch eine oder mehrere Transistorstufen abzuschalten oder umzuschalten, z.B. über HF-Relais (Zweistufensteuerung). Auch hierfür ist ein besonderer Aufwand erforderlich.

Die bekannten Lösungen haben den Nachteil eines zusätzlichen Schaltungsaufwands und damit verbundene Kosten und Raumbedarf. Es können auch Probleme mit der Intermodulation und Kreuzmodulation auftreten. Die zusätzlichen elektronischen Bauelemente liefern zusätzliche elektronische Rauschbeiträge. Für ein günstigeres Intermodulations- und Kreuzmodulations-Verhalten ist bei den bekannten Lösungen nur die obengenannte Zweistufensteuerung möglich.

Der Erfindung liegt die Aufgabe zugrunde, eine Vorrichtung der eingangs geschilderten Art so auszubilden, daß eine Absenkung des Pegels des in einem angeschlossenen Empfänger wirksamen Hochfrequenz-Eingangssignals möglich ist, wobei der Aufwand an Bauteilen gegenüber der eingangs geschilderten Anordnung verringert ist.

Diese Aufgabe wird gemäß der Erfindung dadurch gelöst, daß die Anordnung derart getroffen ist, daß mindestens eines der Halbleiterelemente unabhängig von einem anderen Halbleiterelement steuerbar ist, derart, daß dann, wenn der Empfängeranschluß mit dem Antennenanschluß gekoppelt ist, die dem Empfängeranschluß zuführbare Hochfrequenzleistung durch die Steuerung des mindestens einen Halbleiterelements veränderbar ist.

Bei der Erfindung ist es somit möglich, die im Sende-Empfangs-Umschalter ohnehin vorhandenen HF-Bauteile (pin-Dioden oder Gallium-Arsenid-FETs) bzw. eines dieser Elemente zur Empfangspegelabsenkung zu verwenden. Dadurch entfällt der bei den bekannten Lösungen erforderliche zusätzliche Aufwand, es ergibt sich eine Kostenersparnis, weniger Raumbedarf, es treten keine zusätzlichen elektronischen Rauschbeiträge auf, und es ist eine stufenlose Steuerung oder Regelung der dem Empfänger zugeführten, von der Antenne stammenden HF-Leistung bei gutem Intermodulations- und Kreuzmodulationsverhalten möglich.

Die Erfindung ist bei jeder Art von Sende-Empfangs-Umschalter anwendbar. Falls pin-Dioden verwendet werden, kann selbstverständlich nur Hochfrequenz mit einer Frequenz, die so hoch liegt, daß die pin-Diode einen im wesentlichen ohmschen Widerstand für diese Frequenz bildet, geschaltet werden. Die untere Grenzfrequenz der pin-Diode wird bei der Herstellung durch die Dotierung festgelegt. Ein Anwendungsgebiet, bei dem die Erfindung vorteilhaft anzuwenden ist, wird bei TDMA-Sende-Empfängern gesehen (TDMA = Time Division Multiplex Access, Zeitmultiplexzugriff). In TDMA-Sende-Empfängern wird nicht gleichzeitig gesendet und empfangen, sondern entweder gesendet oder empfangen. In den Sende- bzw. Empfangszeitschlitzen der TDMA-Funksysteme wie z.B. IS-54, IS-136, GSM, DCS1800, PDC, CT2/CT2+, DECT, PHS, werden, meist in sehr kurzen Zeitschlitzen, Datenpakete gesendet oder empfangen. Bei GSM (in Deutschland D1-/D2-Netz) sind die gesendeten bzw. empfangenen Datenpakete 0,57 Millisekunden lang. Die Betriebsfrequenz ist bei etwa 900 MHz.

Bei derartigen Geräten kann beispielsweise jeweils für 0,5 Millisekunden der Sender mit der Antenne verbunden sein, und für 0,5 ms wird der Empfänger mit der Antenne verbunden, und so fort. Obwohl das den Umschalter steuernde Steuersignal hierbei ein Impulssignal ist, wird dieses im folgenden auch als Gleichstrom- oder Gleichspannungssignal bezeichnet, weil die steuerbaren Halbleiterelemente sich nicht wesentlich anders verhalten als beim Steuern mit Gleichspannung oder Gleichstrom.

Bei einer Ausführungsform der Erfindung ist vorgesehen, daß beide genannten Halbleiterelemente unabhängig voneinander steuerbar sind. Dies eröffnet über die normale Sende-/Empfangsumschaltung hinausgehende Möglichkeiten. Bei anderen Ausführungsformen der Erfindung besteht eine Abhängigkeit der Steuerung.

Bei einer Ausführungsform der Erfindung ist vorgesehen, daß in den Hochfrequenzweg vom Senderanschluß zu einem Verzweigungspunkt, an dem der Hochfrequenzweg vom Senderanschluß zum Antennenanschluß und der Hochfrequenzweg vom Antennenanschluß zum Empfängeranschluß aufeinandertreffen, ein erstes Halbleiterelement eingeschaltet ist, daß der Verzweigungspunkt über eine für Gleichstrom durchlässige Hochfrequenzsperre (vorzugsweise Lambda/4-Transformationselement) mit HF-Masse verbunden ist, daß dem ersten Halbleiterelement über einen nicht mit dem Verzweigungspunkt in Verbindung stehenden Anschluß des ersten Halbleiterelements und mittels der Hochfrequenzsperre (Lambda/4-Transformationselement) ein erstes Steuersignal zuführbar ist, um das erste Halbleiterelement für Hochfrequenz durchzuschalten (Sendebetrieb) oder zu sperren (Empfangsbetrieb), daß dem Empfängeranschluß ein zweites Halbleiterelement zugeordnet ist und mindestens ein weiterer Anschluß für ein zweites Steuersignal vorgesehen ist, derart, daß das zweite Halbleiterelement durch das ihm zugeführte zweite Steuersignal in einen für die Hochfrequenz hochohmigen oder niederohmigen Zustand bringbar ist, um die Zufuhr von Hochfrequenz zum Empfängeranschluß zu ermöglichen oder zu verhindern, und in einen eine abgeschwächte Zufuhr von Hochfrequenz zum Empfängeranschluß erlaubenden Zustand bringbar ist.

Dies ermöglicht in einfacher Weise eine Verringerung des Empfangspegels. Als Lambda/4-Transformationselement kann in bekannter Weise ein Lambda/4-Leitungsstück verwendet werden. Das Zuführen des Steuersignals mittels der Hochfrequenzsperre schließt Ausführungsformen ein, bei denen der dem Verzweigungspunkt abgewandte Anschluß der Hochfrequenzsperre mit Masse verbunden ist oder, durch einen Kondensator von Masse getrennt, mit einer von 0 Volt verschiedenen konstanten Betriebsspannung verbunden ist. Da die Erfindung unter anderem im Frequenzbereich von 900 MHz eingesetzt wird, wird nachfolgend zur Vereinfachung die Hochfrequenzsperre, die bei niedrigeren Frequenzbereichen z.B. als Drosselspule ausgebildet sein könnte, meist als Lambda/4-Leitung bezeichnet.

Unterschiedliche Möglichkeiten der Zufuhr der Steuersignale ergeben sich bei Ausführungsformen der Erfindung, bei denen das zweite Halbleiterelement HF-mäßig zwischen den Empfängeranschluß und Masse geschaltet ist, und der HF-mäßig an Masse liegende Anschluß des zweiten Halbleiterelements im Betrieb gleichstrommäßig mit Masse, mit einer von 0 Volt verschiedenen Gleichspannung oder mit einer Steuersignalquelle verbunden ist; und/oder bei denen der HF-mäßig an Masse liegende Anschluß des erstgenannten und/oder des weiteren Lambda/4-Transformationselements im Betrieb gleichstrommäßig mit Masse, mit einer von 0 Volt verschiedenen Gleichspannung oder mit einer Steuersignalquelle verbunden ist. Zur Gleichstromtrennung werden Kondensatoren eingeschaltet, wo nötig.

Zur Erfindung gehört auch ein Hochfrequenz-Sende-Empfangsgerät, das mit einem erfindungsgemäßen Sende-Empfangs-Umschalter ausgerüstet ist, und das unter anderem in den Patentansprüchen 10 und 11 beschrieben ist.

Zur Erfindung gehört auch ein Verfahren zum Steuern eines Sende-Empfangs-Umschalters in der Weise, daß der Hochfrequenzpegel am Empfängeranschluß auf einen vorbestimmten Maximalwert begrenzt wird. Zur Begrenzung dient eine Hochfrequenzpegel-Dämpfungsregelung. Neben dem Empfang ohne Dämpfung genügt oft ein einziger, über Steuerspannung bzw. Steuerstrom einstellbarer diskreter Dämpfungswert (z.B. -20dB oder -30dB). Die Empfängerdynamik von z.B. 80dB kann dann bei Bedarf um den Dämpfungswert erweitert werden. Der Zusammenhang von Steuerspannung bzw. Steuerstrom und Dämpfung muß genau bekannt sein, damit der Empfangs-Hochfrequenzpegel am Antennenanschluß des Sende-Empfangs-Umschalters vom Hochfrequenz-Sende-Empfangsgerät ermittelt werden kann.

Weitere Merkmale und Vorteile der Erfindung ergeben sich aus der nachfolgenden Beschreibung von Ausführungsbeispielen der Erfindung anhand der Zeichnung, die erfindungswesentliche Einzelheiten zeigt, und aus den Ansprüchen. Die einzelnen Merkmale können je einzeln für sich oder zu mehreren in beliebiger Kombination bei einer Ausführungsform der Erfindung verwirklicht sein.

Es zeigen:
Figur 1 ein schematisches Schaltbild, teilweise als Blockschaltbild, eines erfindungsgemäßen Sende-Empfangs-Geräts mit einem erfindungsgemäßen Sende-Empfangs-Umschalter mit vollständig getrennter Steuerbarkeit der beiden pin-Dioden;
Figur 2 eine zweite Ausführungsform eines Sende-Empfangs-Umschalters mit vollständig getrennter Steuerbarkeit der beiden pin-Dioden, die bei einem Sende-Empfangs-Gerät, das nur geringfügig modifiziert ist, einsetzbar ist;
Figur 3 ein drittes Ausführungsbeispiel eines Sende-Empfangs-Umschalters mit gestufter Steuerbarkeit; (positiv)
Figur 4 ein viertes Ausführungsbeispiel eines Sende-Empfangs-Umschalters, ebenfalls mit gestufter Steuerbarkeit; (negativ)
Figur 5 eine bekannte Schaltung eines Sende-Empfangs-Umschalters.

Bei allen Figuren ist der zum Anschluß einer Antenne vorgesehene Antennenanschluß des Sende-Empfangs-Umschalters mit ANT bezeichnet, der für den Empfängereingang vorgesehene Empfängeranschluß mit RX, und der für den Senderausgang vorgesehene Senderanschluß mit TX. Die Anordnungen sind für im wesentliche schmalbandige Anwendungen dargestellt, so daß die in allen gezeigten Anordnungen vorgesehenen Lambda/4-Leitungsstücke ihre wesentlichen Transformationseigenschaften im gesamten interessierenden Bereich der Hochfrequenz aufweisen, nämlich unter anderem die Transformation eines Kurzschlusses am Ausgang in einen sehr hohen Widerstand am Eingang der jeweiligen Lambda/4-Leitung. Die Lambda/4-Leitungsstücke sind als ausgefüllte quaderförmige Elemente dargestellt und jeweils mit Lambda/4 bezeichnet.

In der bekannten Anordnungen nach Fig. 5 ist der Senderanschluß TX über einen HF Koppelkondensator C1 mit einem Verbindungspunkt verbunden, der einerseits über eine Lambda/4-Leitung L1 und einen Kondensator C2 mit Masse verbunden ist, andererseits mit der Anode einer ersten pin-Diode D1 verbunden ist, deren Kathode mit einem Verzweigungspunkt P verbunden ist, der einerseits über einen Koppelkondensator C3 mit dem Antennenanschluß ANT verbunden ist, andererseits über eine Lambda/4-Leitung L2 mit einem Verbindungspunkt Q verbunden ist, der einerseits über einen Koppelkondensator C4 mit dem Empfängeranschluß RX und andererseits mit der Anode einer zweiten pin-Diode D2 verbunden ist, deren Kathode mit Masse verbunden ist. Der Verbindungspunkt der Lambda/4-Leitung L1 mit dem Kondensator C2 ist über einen zur Strombegrenzung dienenden ohmschen Widerstand R mit einer Steuerspannungsquelle VC1 mit positiver Polarität verbindbar, deren anderer Anschluß mit Masse zu verbinden ist. Liegt die Steuerspannung VC1 am Widerstand R an, so werden beide pin-Dioden D1 und D2 in Durchlaßrichtung von einem Gleichstrom durchflossen. Beide pin-Dioden haben dann für Hochfrequenz einen geringen Widerstand. Daher ist für Hochfrequenz der Weg von dem Senderanschluß zum Antennenanschluß frei. Andererseits aber besteht zwischen dem Empfängeranschluß RX und Masse nahezu ein Kurzschluß, so daß Hochfrequenz von der Antenne auch wegen der Blockierung durch die zweite Lambda/4-Leitung L2 nicht zum Empfängeranschluß gelangen kann.

Liegt an der Anschlußklemme VC1 keine Steuerspannung an (VC1 = 0 Volt), so sind beide pin-Dioden für die Hochfrequenz hochohmig, so daß einerseits der Weg vom Senderanschluß zum Antennenanschluß gesperrt ist und andererseits der Weg vom Antennenanschluß zum Empfängeranschluß für die Hochfrequenz frei ist. Der Eingangswiderstand eines am Empfängeranschluß RX angeschlossenen Empfängers wird im allgemeinen dem Wellenwiderstand der verwendeten Hochfrequenz-Leitungen entsprechen Beide pin-Dioden D1 und D2 werden gleichzeitig zwischen einem hochohmigen und einem niederohmigen Zustand umgeschaltet.

Demgegenüber ist es ein wesentliches Merkmal der Erfindung, daß die dem Empfängereingang zugeordnete pin-Diode oder allgemein das dem Empfängereingang zugeordnete, für die Hochfrequenz einen schaltbaren ohmschen Widerstand bildende Halbleiterbauelement (z.B. ein GaAs-FET) so ausgebildet ist, daß bei auf Empfangsbetrieb geschaltetem Umschalter bei schwachem Eingangssignal die von dem Antennenanschluß kommende Hochfrequenzleistung möglichst ungedämpft dem Empfängeranschluß zugeführt wird, daß aber dann, wenn die von der Antenne empfangene Hochfrequenz für eine störungsfreie Verarbeitung einen zu hohen Pegel hat, durch Veränderung des ohmschen Widerstands des dem Empfängeranschluß zugeordneten steuerbaren Halbleiterelements die dem Empfängeranschluß zugeführte Hochfrequenzleistung verringert werden kann; dabei wird jedoch die Zufuhr von Hochfrequenz zum Empfängeranschluß normalerweise nicht vollständig unterdrückt.

Bei den dargestellten Beispielen, wie auch beim Stand der Technik, ist das dem Empfängeranschluß zugeordnete Halbleiterelement parallel zu diesem geschaltet. In diesem Fall wird zwecks Steuerung oder Regelung des Empfangspegels erfindungsgemäß das steuerbare Halbleiterelement so gesteuert, daß sich sein ohmscher Widerstand bei zu starken Antennensignal von einem sehr hohen ohmschen Wert ausgehend verkleinert, ohne jedoch normalerweise den Wert 0 anzunehmen.

Es sind auch Ausführungsformen der Erfindung denkbar, bei denen im Weg der Hochfrequenz von Antennenanschluß zum Empfängeranschluß ein steuerbares Halbleiterelement in Serie angeordnet ist. In einem derartigen Fall würde bei zu starkem von der Antenne kommenden Hochfrequenzpegel der ohmsche Widerstand dieses Halbleiterelements von einem sehr kleinen Wert ausgehend vergrößert werden, ohne jedoch normalerweise einen für den gesperrten Zustand charakteristischen extrem hohen Wert zu erreichen. Es versteht sich, daß in einem derartigen Fall die zwischen dem Antennenanschluß und dem Empfängeranschluß liegende Lambda/4-Leitung durch ein sehr kurzes Leitungsstück oder durch eine Lambda/2-Leitung ersetzt werden sollte.

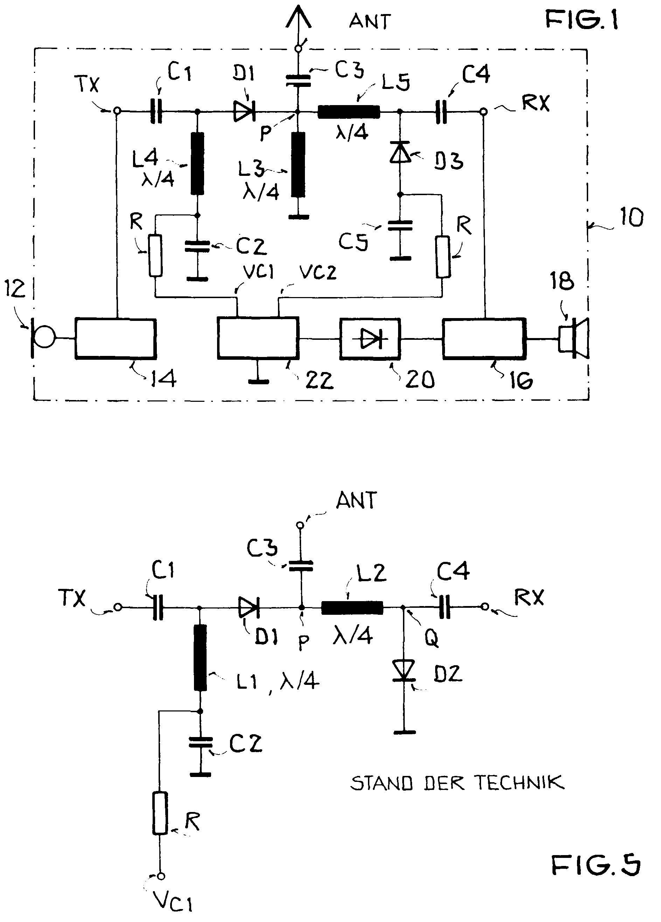

Bei der in Fig. 1 gezeigten Anordnung weist der Sende-Empfangs-Umschalter die in Fig. 5 gezeigten Bauelemente auf, mit dem Unterschied, daß die zweite pin-Diode umgekehrt gepolt und mit einem abweichenden Bezugszeichen D3 bezeichnet ist. Auch die Lambda/4-Leitungen sind abweichend bezeichnet. Der Verzweigungspunkt P ist über eine Lambda/4-Leitung L3 mit Masse verbunden. Die Lambda/4-Leitung L1 von Fig. 5 ist hier als weitere Lambda/4-Leitung L4 bezeichnet, die Lambda/4-Leitung L2 von Fig. 5 als Lambda/4-Leitung L5. Die Lambda/4-Leitung L3 ist dazu vorgesehen, zwei getrennte Gleichstromwege zum Steuern der pin-Dioden zu schaffen. Sie könnte durch eine andere geeignete Hochfrequenzsperre gebildet werden. Die Anode der Diode D3 ist einerseits über einen Kondensator C5 mit Masse und andererseits über einen Widerstand R mit einem Anschluß VC2 für eine Versorgungsspannungsquelle verbunden. Die Versorgungsspannungsquellen, die mit den Anschlüssen VC1 und VC2 verbindbar sind, sind mit ihrem jeweils anderen Pol mit Masse zu verbinden. Es ergeben sich folgende Schaltungsmöglichkeiten:

Steuerspannungen VC1 und VC2 positiv (z.B. +5 Volt): Beide pin-Dioden D1 und D3 werden von einem Gleichstrom durchflossen. Wie anhand der Fig. 5 ausgeführt, ist dadurch der Umschalter auf Sendebetrieb geschaltet.

VC1 0 Volt, VC2 0 Volt: Beide pin-Dioden D1 und D3 werden nicht von Gleichstrom durchflossen, ihr für die Hochfrequenz wirksamer Widerstand ist daher sehr groß, dies entspricht dem anhand der Fig. 5 geschilderten Zustand, bei dem der Umschalter auf Empfang geschaltet ist.

Steuerspannung VC1 0 Volt, VC2 positiv, aber kleiner als bei auf Sendebetrieb geschalteten Umschalter: Hier ist der Umschalter auf Empfangsbetrieb geschaltet, es wird aber dem Empfängeranschluß RX nicht die volle von der Antenne kommende Hochfrequenzleistung zugeführt, weil der ohmsche Widerstand der pin-Diode D3 so klein ist, daß er merkliche Teile der Hochfrequenzleistung nach Masse ableitet bzw. in D3 in Wärme umwandelt, andererseits nicht so groß ist, daß die gesamte Hochfrequenz zum Empfängeranschluß gelangen kann.

Als Blockschaltbild sind in Fig. 1 noch die für das Verständnis der Erfindung wesentlichen Teile eines Sende-Empfangs-Geräts, z.B. eines in einem einzigen Gehäuse 10 untergebrachten Funktelefons dargestellt. Das Gehäuse 10 läßt in der stark vereinfachten Fig. 1 die tatsächliche Gestalt des Geräts nicht erkennen. Im Gehäuse 10 ist ein Mikrofon 12 angeordnet, das die von Benutzer stammenden Sprachsignale durch ein Sendeteil 14 (Verstärker- und Senderanordnung) verstärkt und in geeignet modulierte Hochfrequenz umwandelt, die über eine Leitung dem Senderanschluß TX zuführbar ist. Der Empfängeranschluß RX ist über eine Leitung mit einem Eingang eines Empfangsteils 16 (Empfangsverstärker und Demodulator sowie NF-Verstärker) verbunden, das über geeignete Demodulation der Datenpakete einen Lautsprecher oder Hörer 18 speist, an dem der Benutzer mit dem Ohr die empfangenen Nachrichten wahrnehmen kann. Das Empfangsteil 16 weist eine Vorrichtung 20 auf, die der Deutlichkeit halber außerhalb des Geräteteils 16 dargestellt ist, die ein Ausgangssignal liefert, das ein Maß für den Pegel des dem Empfängeranschluß RX zugeführten, von der Antenne stammenden HF-Signals ist. Das Ausgangssignal der Einrichtung 20 wird einer Steuervorrichtung 22 zugeführt, die einen Taktgenerator enthält, der in der eingangs geschilderten Weise den Sende-Empfangs-Umschalter ständig zwischen Sendezustand und Empfangszustand umschaltet, und außerdem im Empfangszustand in Abhängigkeit von dem von der Einrichtung 20 gelieferten Ausgangssignal dem Anschluß VC2 eine Spannung derjenigen Höhe zuführt, die für die jeweils erforderliche Dämpfung des HF-Signals nötig ist.

Die Steuervorrichtung 22 ist mit den Anschlüssen VC1 und VC2 durch getrennte Steuerleitungen verbunden und außerdem mit Masse verbunden, so daß sie zwei getrennte Steuerspannungen dem Sende-Empfangs-Umschalter zuführen kann.

Die senderseitige Lambda/4-Leitung dient nur als gleichstromleitende Hochfrequenzsperre, während bei der empfängerseitigen Lambda/4-Leitung deren bekannte Transformationseigenschaften für unterschiedliche Abschlußwiderstände genutzt werden, wie auch beim Stand der Technik.

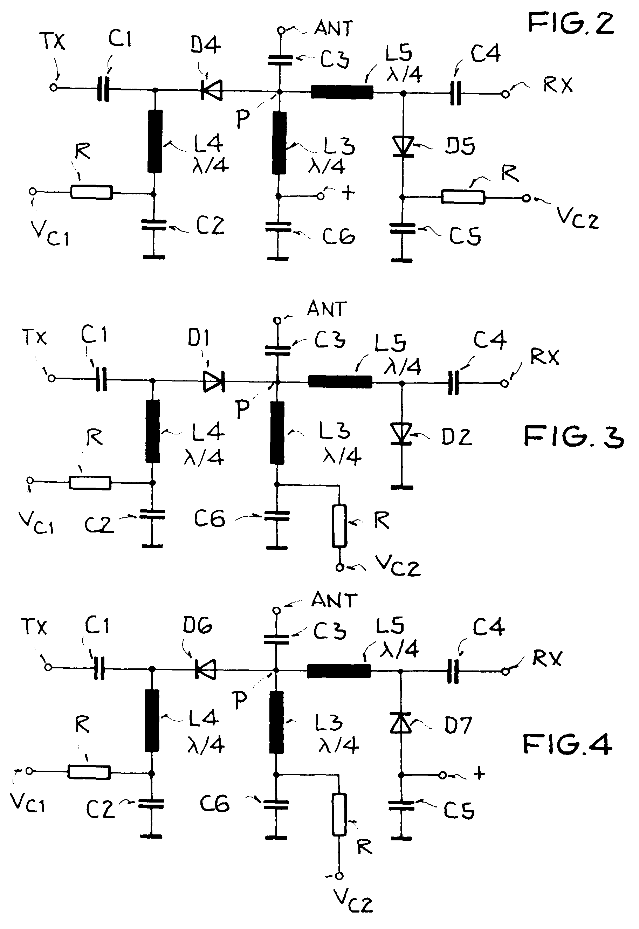

Während bei der Anordnung nach Fig. 1 die Steuerspannungen VC1 und VC2 gegenüber Masse positiv sind, ist die in Fig. 2 gezeigte Anordnung so abgewandelt, daß die Steuerspannungen VC1 und VC2 negativ sein müssen, wenn sie die entsprechenden pin-Dioden, die hier die Bezugszeichen D4 und D5 haben, mit einem Strom in Durchlaßrichtung beaufschlagen sollen. In Abweichung zur Fig. 1 ist hier der dem Antennenanschluß ANT abgewandte Anschluß der Lambda/4-Leitung L3 nicht gleichstrommäßig mit Masse verbunden, sondern über einen Kondensator C6 hochfrequenzmäßig mit Masse verbunden und an den soeben genannten Anschluß der Lambda/4-Leitung L3 ist eine positive Betriebsspannung anschließbar. Die den Anschlüssen VC1 und VC2 zuführbaren Steuerspannungen können nun entweder gegenüber Masse negativ sein, um die entsprechenden pin-Dioden DA und D5 mit einem Durchlaßstrom zu beaufschlagen, oder aber sie können gegenüber Masse positiv sein, jedoch gegenüber der der Lambda/4-Leitung L3 zugeführten positiven Gleichspannung (Betriebsspannung) niedriger liegen, so daß auch in diesem Fall ein Gleichstrom durch die Dioden D4 und D5 fließt. Auch hier kann durch Anlegen geeigneter Spannungen an die Anschlüsse VC1 und VC2 zwischen Sendebetrieb und Empfangsbetrieb umgeschaltet werden, und im Empfangsbetrieb der für Hochfrequenz wirksame ohmsche Widerstand der Diode D5 ausgehend von einem sehr hohen Wert in Richtung auf niedrigere Werte zwecks Dämpfung des dem Empfängeranschluß RX zugeführten Hochfrequenzsignals verändert werden.

Bei der Anordnung nach Fig. 2 sind die pin-Dioden D4 und D5 jeweils im Vergleich zu der Anordnung nach Fig. 1 entgegengesetzt gepolt.

Bei der Anordnung nach Fig. 3 sind die pin-Dioden D1 und D2 so gepolt wie bei der bekannten Anordnung nach Fig. 5, die Beschaltung der weiteren Lambda/4-Leitung L4 mit Versorgungsmöglichkeit durch eine erste Steuerspannung VC1 stimmt ebenfalls mit Fig. 5 überein, jedoch ist in Übereinstimmung mit den Fig. 1 und 2 auch hier die Lambda/4-Leitung L3 vorgesehen, die am Verzweigungspunkt P (Verbindungspunkt der Diode D1 mit der Lambda/4-Leitung L5 und mit dem Antennenkoppelkondensators C3) angeschlossen ist. An dem anderen Anschluß der Lambda/4-Leitung L3 ist, ähnlich wie bei Fig. 2, durch einen Kondensator C6 von Masse gleichstrommäßig getrennt ein Anschluß VC2 vorgesehen, der über einen Widerstand R einen Strom in den unteren Anschluß der Leitung L3 einspeisen kann. Ist die Spannung VC1 positiv und die Spannung VC2 0 Volt, so werden beide Dioden D1 und D2 von einem Gleichstrom durchflossen und die Anordnung ist, wie bereits beschrieben, auf Sendebetrieb geschaltet. Ist die Spannung VC1 0 Volt und die Spannung VC2 ebenfalls 0 Volt, so ist die Anordnung auf Empfangsbetrieb geschaltet, wobei die von der Antenne zum Empfängereingang RX fließende HF-Leistung nicht gedämpft ist. Wird nun die Steuerspannung VC2 von in Richtung auf positive Werte vergrößert, so fließt durch die dem Empfängeranschluß RX zugeordnete Diode D2 ein von 0 an ansteigender Gleichstrom, der den ohmschen Widerstand dieser Diode in Richtung auf kleinere Werte verändert und dadurch die am Empfängeranschluß RX zur Verfügung stehende Hochfrequenzleistung reduziert.

Bei der Anordnung nach Fig. 4 sind die hier mit dem Bezugszeichen D6 und D7 bezeichneten pin-Dioden im Vergleich zu der Anordnung nach Fig. 3 entgegengesetzt gepolt. Die dem Hochfrequenzsignalweg zum Empfängeranschluß abgewandte Anode der Diode D7 ist von Masse durch einen Kondensator C5 getrennt und an dieser Anode ist eine positive Versorgungsspannung anschließbar. Die dem Hochfrequenzweg abgewandten Enden der Lambda/4-Leitungen L3 und L4 sind mit den gleichen Bauelementen beschaltet wie bei der Anordnung nach Fig. 3, jedoch sind die an die in Fig. 4 vorgesehenen Steuerklemmen VC1 und VC2 z.B. in folgender Weise zu wählen:

Für den Sendebetrieb muß die dem Steueranschluß VC1 zugeführte Steuerspannung einen Wert haben, der um so viel in Richtung auf negative Werte gegenüber der der Anode der Diode D7 zugeführten Spannung ist, daß beide Dioden D6 und D7 für die verwendete Hochfrequenz einen niederohmigen Zustand haben.

Für den Empfangsbetrieb ohne Dämpfung der dem Anschluß RX zugeführten HF-Leistung sind z.B. beide Anschlüsse VC1 und VC2 von einer Versorgungsspannungsquelle zu trennen, so daß es nicht möglich ist, daß ein Gleichstrom durch die Dioden D6 und D7 fließt. Für den Empfangsbetrieb mit Dämpfung ist z.B. der Steueranschluß VC1 von einer Versorgungsspannungsquelle zu trennen, so daß durch die Diode D6 kein Gleichstrom fließen kann und diese daher für Hochfrequenz gesperrt ist, und dem Anschluß VC2 ist eine solche Spannung zuzuführen, daß durch die Diode D7 ein so kleiner Gleichstrom fließt, daß zwar einerseits durch diese Diode D7 Hochfrequenzleistung nach Masse abgeleitet wird, aber andererseits noch Leistung am Empfängeranschluß RX zur Verfügung steht.

Bei allen in den Ausführungsbeispielen gezeigten erfindungsgemäßen Anordnungen sind die Dioden durch pin-Dioden gebildet. Stattdessen können auch andere Halbleiterbauelemente verwendet werden, die als steuerbare ohmsche Widerstände für die verwendete Hochfrequenz verwendet werden können, insbesondere GaAs-Feldeffekttransistoren.

Bei den erfindungsgemäßen Ausführungsbeispielen gemäß Fig. 1 bis 4 ist es möglich, daß durch entsprechende Wahl der Steuerströme bzw. Steuerspannungen, die von den geschilderten Werten abweichen, Hochfrequenz direkt vom Senderanschluß zum Empfängeranschluß gelangen kann. Dies ist zwar in den meisten Fällen unerwünscht, wenn nicht möglicherweise sogar für den Empfangsteil schädlich und sollte daher durch geeignete Ausbildung der Schaltung, insbesondere auch der Steuervorrichtung 22 verhindert werden. Es kann jedoch im Einzelfall, z.B. für Prüfzwecke, nützlich sein, von dieser Möglichkeit Gebrauch zu machen. Z.B. könnte das Gerät eine Prüftaste haben, die den Pegel der im Gerät erzeugten Hochfrequenzleistung extrem stark absenkt und dann eine Durchschaltung zum Empfängeranschluß bewirkt. Der Benutzer oder ein Servicetechniker könnte auf diese Weise in der Lage sein, am Gerät selbst ohne separates Meßgerät die Funktionsfähigkeit des Sendeteils und Empfangsteils grob zu beurteilen.

Für die Erfindung ist es nicht notwendig, daß die Diode D1 und die Lambda/4-Leitung L4 sich in der gezeigten Weise außerhalb des Sendeteils 14 befindet. Wenn das Sendeteil 14 so ausgebildet ist, daß es in den Sendeintervallen einen im Sendeteil angeordneten, der Diode D1 entspechenden Schalter leitend steuert, oder der Diode D1 in den Figuren 1 bis 4 eine Gleichspannung zuführt, so sind derartige Anordnungen ebenfalls funktionsfähig und gehören zur Erfindung, weil auch bei diesen ein Sende-Empfangs-Umschalter vorhanden ist.

## Patentansprüche

1. Sende-Empfangs-Umschalter mit einem Senderanschluß, einem Empfängeranschluß und einem Antennenanschluß zum Anschluß eines Hochfrequenz-Senderausgangs, Empfängereingangs bzw. einer Antenne, mit einem dem Sendeweg vom Senderanschluß zum Antennenanschluß und einem dem Empfangsweg vom Antennenanschluß zum Empfängeranschluß zugeordneten steuerbaren Halbleiterelement als Hochfrequenzschalter, mit Anschlüssen zum Zuführen eines Steuersignals (Strom oder Spannung) zu den Halbleiterelementen, wobei die Halbleiterelemente in Abhängigkeit von ihrer Ansteuerung durch ein Steuersignal einen für die zu schaltende Hochfrequenz annähernd ohmschen steuerbaren Widerstand bilden,
dadurch gekennzeichnet, daß
die Anordnung derart getroffen ist, daß mindestens eines (D2, D3, D5, D7) der Halbleiterelemente unabhängig von einem anderen Halbleiterelement steuerbar ist, derart, daß dann, wenn der Empfängeranschluß (RX) mit dem Antennenanschluß (ANT) gekoppelt ist, die dem Empfängeranschluß zuführbare Hochfrequenzleistung durch die Steuerung des mindestens einen Halbleiterelements veränderbar ist.

2. Sende-Empfangs-Umschalter nach Anspruch 1, dadurch gekennzeichnet, daß beide genannten Halbleiterelemente unabhängig voneinander steuerbar sind.

3. Sende-Empfangs-Umschalter nach einem der vorhergehenden Ansprüche, dadurch gekennzeichnet, daß in den Hochfrequenzweg vom Senderanschluß zu einem Verzweigungspunkt (P), an dem der Hochfrequenzweg vom Senderanschluß zum Antennenanschluß und der Hochfrequenzweg vom Antennenanschluß zum Empfängeranschluß aufeinandertreffen, ein erstes Halbleiterelement (D1, D4, D6) eingeschaltet ist, daß der Verzweigungspunkt (P) über eine gleichstromleitende Hochfrequenzsperre (vorzugsweise Lambda/4-Transformationselement L3) mit HF-Masse verbunden ist, daß dem ersten Halbleiterelement (D1, D4, D6) über einen nicht mit dem Verzweigungspunkt (P) in Verbindung stehenden Anschluß des ersten Halbleiterelements und mittels der Hochfrequenzsperre (Lambda/4-Transformationselement) ein erstes Steuersignal zuführbar ist, um das erste Halbleiterelement für Hochfrequenz durchzuschalten (Sendebetrieb) oder zu sperren (Empfangsbetrieb), daß dem Empfängeranschluß (RX) ein zweites Halbleiterelement (D2, D3, D5, D7) zugeordnet ist und mindestens ein weiterer Anschluß für ein zweites Steuersignal vorgesehen ist, derart, daß das zweite Halbleiterelement durch das ihm zugeführte zweite Steuersignal in einen für die Hochfrequenz hochohmigen oder niederohmigen Zustand bringbar ist, um die Zufuhr von Hochfrequenz zum Empfängeranschluß zu ermöglichen oder zu verhindern, und in einen eine abgeschwächte Zufuhr von Hochfrequenz zum Empfängeranschluß erlaubenden Zustand bringbar ist.

4. Sende-Empfangs-Umschalter nach Anspruch 3, dadurch gekennzeichnet, daß die beiden Hochfrequenzanschlüsse des ersten Halbleiterelements jeweils über das Lambda/4-Transformationselement (L3) und ein weiteres Lambda/4-Transformationselement (L4) mit HF-Masse verbunden sind, daß dem ersten Halbleiterelement über die genannten Lambda/4-Transformationselemente Gleichstrom oder Gleichspannung zuführbar ist, um das erste Halbleiterelement für Hochfrequenz durchzuschalten oder zu sperren.

5. Sende-Empfangs-Umschalter nach Anspruch 3 oder 4, dadurch gekennzeichnet, daß das zweite Halbleiterelement HF-mäßig zwischen den Empfängeranschluß (RX) und Masse geschaltet ist, und daß der HF-mäßig an Masse liegende Anschluß des zweiten Halbleiterelements im Betrieb gleichstrommäßig mit Masse, mit einer von 0 Volt verschiedenen Gleichspannung oder mit einer Steuersignalquelle verbunden ist.

6. Sende-Empfangs-Umschalter nach einem der Ansprüche 3 bis 5, dadurch gekennzeichnet, daß der HF-mäßig an Masse liegende Anschluß des erstgenannten (L3) und/oder des weiteren (L4) Lambda/4-Transformationselements im Betrieb gleichstrommäßig mit Masse, mit einer von 0 Volt verschiedenen Gleichspannung oder mit einer Steuersignalquelle verbunden ist.

7. Sende-Empfangs-Umschalter nach einem der vorhergehenden Ansprüche, dadurch gekennzeichnet, daß mindestens ein Halbleiterelement eine pin-Diode ist.

8. Sende-Empfangs-Umschalter nach einem der vorhergehenden Ansprüche, dadurch gekennzeichnet, daß mindestens ein Halbleiterelement ein Gallium-Arsenid-Feldeffekttransistor ist.

9. Sende-Empfangs-Umschalter nach einem der vorhergehenden Ansprüche, dadurch gekennzeichnet, daß er eine Einrichtung zum Feststellen des Hochfrequenz-Pegels am Empfängeranschluß und zum Begrenzen des Hochfrequenz-Pegels am Empfängeranschluß auf einen vorbestimmten Maximalwert beim Empfangsbetrieb aufweist.

10. Hochfrequenz-Sende-Empfangs-Gerät mit einem Sende-Empfangs-Umschalter und mit Mitteln zum Absenken des Empfangspegels des Geräts, dadurch gekennzeichnet, daß der Sende-Empfangs-Umschalter nach einem der vorhergehenden Ansprüche ausgebildet ist, derart, daß der Empfangspegel durch den Sende-Empfangs-Umschalter absenkbar ist.

11. Gerät nach Anspruch 10, dadurch gekennzeichnet, daß ein Empfangsteil (16) des Geräts eine Vorrichtung (20) zum Erzeugen eines vom Hochfrequenz-Pegel am Empfängereingang (RX) abhängigen Steuersignals aufweist, das dem Sende-Empfangs-Umschalter zugeführt wird, derart, daß der genannte Pegel beim Empfangsbetrieb ein vorbestimmtes Maß nicht überschreitet.

12. Verfahren zum Steuern eines Sende-Empfangs-Umschalters nach einem der vorhergehenden Ansprüche in der Art, daß der Hochfrequenz-Pegel am Empfängeranschluß auf einen vorbestimmten Maximalwert begrenzt wird.

13. Verfahren nach Anspruch 12, dadurch gekennzeichnet, daß zur Begrenzung eine Hochfrequenzpegel-Dämpfungsregelung verwendet wird.

14. Vorrichtung und Verfahren nach einem der vorhergehenden Ansprüche, dadurch gekennzeichnet, daß ein über Steuerspannung bzw. Steuerstrom einstellbarer diskreter Dämpfungswert vorgesehen ist.
